# EUROPEAN PATENT APPLICATION

(11) **EP 2 713 291 A1**
(43) Date of publication of application: **02.04.2014**
(21) Application number: 12186279.1
(22) Date of filing: 27.09.2012
(51) Int. Cl.: G06F 17/50

(54) **Method for constructing a clock tree**

(71) Applicant: Technische Universität Darmstadt, 64285 Darmstadt (DE)
(72) Inventor: Königsmark, Sven, 22589 Hamburg (DE); Jaiswal, Ashok, 64295 Darmstadt (DE); Hofmann, Klaus, 64291 Darmstadt (DE)
(74) Representative: Stumpf, Peter

(57) **Abstract**

A method (8) for constructing a clock tree (1) in an electronic device (36, 37) is suggested, in which a central clock signal is distributed to a plurality of sinks (5), said method (8) comprising the steps of
(a) introducing (10, 16) buffers (7) into the clock tree (1),
(b) checking (12, 15, 22, 23, 24, 25, 31) their effect on the clock signal at at least some of the sinks (5) of said clock tree (1), and
(c) removing (17, 34) the respective buffer (7) if adverse effects are obtained. According to the suggested method (8) at least one buffer (7) can be introduced into the clock tree (1) independent of nodes (3) of said clock tree (1).

## Description

The invention relates to a method for constructing a clock tree in an electronic device, in which a central clock signal is distributed to a plurality of sinks. Furthermore, the invention relates to an electronic device. The invention also relates to a computer program product and to a construction device for constructing a clock tree in an electronic device.

In current computer technology, integrated circuits comprising a plethora of digital circuitry are used. To ensure a common operation of such digital circuitry, such circuits have to operate at a somewhat similar time so that the output of one digital circuit can be used as an input of another digital circuit. To provide such functionality, it is standard practice to operate the circuitry at (essentially) common times. This is realised by providing a so-called clock signal that is distributed to various components and wherein the various components work according to a work cycle, set forth by the clock cycle.

To distribute the clock signal of a central clock signal generating device to the various digital circuits (wherein these circuits are consumers or sinks with regard to the clock signal), a (single) clock signal source has to be split up into a usually large number of branches (serving the various sinks). Since this topology resembles somewhat a tree, such a distribution of a (originally) single clock signal into a plurality of clock signals that are fed to the sinks, is usually referred to as a clock tree.

With nowadays clock signal frequencies in the GHz range and the current integrated circuit sizes of several mm² (i.e. devices with a length of several centimetres cross), it is usually not possible any more to operate all circuits at an essentially identical time. Therefore, nowadays integrated circuits are regularly split up into a number of local areas, in which the circuits are operating at essentially the same time, while two different local areas might operate according to a different clocking scheme (i.e. somewhat independent of each other). With nowadays integrated circuits, more complex integrated circuits typically show a number of local areas that ranges in the order of some 100 local areas. As it is clear, the clock tree has to account for this type of topology. Therefore, the clock tree is divided into a number of individual groups (branches), wherein the sinks in the individual local areas (branches) are provided with a similar clocking signal, while the clocking signal in different branches (i.e. in different local areas) might vary.

This is usually realised by splitting up the initial clocking signal through several stages of nodes, where an input line is split up several times into two or more output lines on which the clock signal is transmitted.

To ensure a "teamwork" of the circuits within a local area, a "similar clock signal" has to be provided that has to obey certain standards which are defined according to the specifications of a technical standard. In particular, a so-called skew limit and a so-called slew limit have to be obeyed. The skew is defined as the time difference between the arrival of a signal at two different sinks (for example the beginning of a rising flank of a clock signal at the respective sinks). The slew rate corresponds to the "spreading" of a digital signal (for example the beginning and the end of a rising flank of a digital clock signal).

Both the skew rate and the slew rate are influenced by the electric lines, on which they are routed. An influence can occur due to the length of the respective line, the presence of a node (i.e. a branching electric connection), including its position along an electric line, a changeover between different layers of a multi-layered integrated circuit (quite often referred to as the "metals"), the distance between neighbouring conductors (because of their electric capacitance), the widths of the electric lines and so on.

It is also known that the introduction of one or more amplifiers (so-called buffers) has an influence on the skew rate and slew rate as well. While a buffer introduces a certain time delay (which is somewhat fixed), it can actually "speed up a signal", because a "long line" can be divided into a "series of two shorter lines". This can decrease a propagation time, because the propagation time usually increases quadratically with the length of the line. Additionally, a buffer typically limits the slew rate as well, usually even significantly.

A major adverse effect of the introduction of buffers is their power consumption and the space that is needed for them. Furthermore, the presence of buffers (but also of other circuits and even of electrical lines) typically gives rise to a certain susceptibility to process variations. I.e., the time delays and/or the influence on the signal shape (and therefore an influence on skew rate and slew rate) can vary with temperature and operating voltage in a non-linear and hence in a somewhat unpredictable way. Therefore, a "good compromise" between as many buffers as necessary and as few buffers as possible has to be made.

Even worse, an operation of a major number of components at the very same time is not desired anymore with nowadays integrated circuits. On the contrary, such an operation at an identical time is highly undesired, since this will lead to unwanted peaks in energy consumption at certain times. This will not only lead to an increased power demand at certain times (and hence probably to voltage fluctuations and so on), but also to so-called "hotspots", i.e. small areas with an increased temperature. These hotspots can cause errors when computing (because the skew rate and the slew rate will usually vary with temperature in a non-linear way), but can even result in a destruction of the electronic device.

Therefore, one has to look for a clock tree that is "spreading" the clock signal at the various sinks in a local area, while obeying the skew limit and slew limit (and other limits) set forth by the technical standard of the respective device. In particular the "arrival" of the clock signal should be somewhat evenly distributed in a local area.

To achieve such a clock tree, various methods for constructing a clock tree have been suggested.

Such a method was suggested in "Buffer Placement in Distributed RC-tree Networks for Minimal Elmore Delay" by Lukas P.P.P. van Ginneken "IEEE International Symposium on Circuits and Systems", 1990, pages 865 to 868. The therein described algorithm comprises two stages, namely a first phase, in which the different nodes of a clocking tree are determined. In a second phase, it is checked whether the placement of a buffer (amplifier) in connection with the already constructed nodes will result in an improved clocking tree. A major problem for the therein described algorithm is that it tries to minimise the overall delay between the root and the leaves (i.e. between the clocking signal source and the sinks). Skew rates or slew rates are not considered. Therefore, one cannot be certain whether a maximum skew rate or slew rate is obeyed in a certain local area, or not. Furthermore, a spreading of the clock signal at the sinks (so that the respective circuits do not operate at the very same time) is not considered either.

An improved construction algorithm has been suggested in "Fast Algorithms for Slew Constrained Minimum Cost Buffering" by S. Hu, C. J. Alpert, J. Hu, S. Karandikar, Z. Li, W. Shi and C. N. Sze in IEEE Transactions on Computer-aided Design of Integrated Circuits and Systems, Vol. 26, No. 11, November 2007, pages 1 to 14. The method that is proposed in this publication considers slew rate when constructing a clock tree. This is done by "provisionally introducing" buffers in connection with nodes and checking for the effect that comes along with adding said buffer. However, the solution does not consider time delays or skew rate, which are both important for the functioning of a clock tree.

Yet another proposal has been made in United States patent US 6,725,389 B1. Here, a buffer is provided for a branch of a clock tree. Then, the buffer is shifted in a way to minimise skew rate for the sinks in the respective branch of the clock tree. However, slew rate is not considered.

Although it is clearly possible to design working integrated circuits using presently available construction techniques for clock trees, the construction method and/or the resulting integrated circuits still show deficiencies. In particular, present construction methods usually require a substantive amount of calculating power. Furthermore, present day techniques still require a manual intervention frequently and/or are operating on a trial and error basis.

Furthermore, the integrated circuits that can be achieved with nowadays techniques quite often show a significant presence of hotspots. This can shorten the lifetime of the respective integrated circuit and/or prevent further miniaturisation of the integrated circuits.

It is therefore the object of the invention to provide a method for constructing a clock tree in an electronic device that is improved over presently available methods for constructing a clock tree in an electronic device. Furthermore it is an object of the invention to provide an electronic device that is improved over electronic devices according to the state-of-the-art. Other objects of the invention are to provide an improved computer program product and an improved construction device for constructing a clock tree.

The invention solves these objects.

It is suggested to perform a method for constructing a clock tree in an electronic device, in which a central clock signal is distributed to a plurality of sinks, and wherein said method comprises the steps of (a) introducing buffers into the clock tree, (b) checking their effect on the clock signal at at least some of the sinks of said clock tree and (c) removing the respective buffer if adverse effects are obtained in a way that at least one buffer can be introduced into the clock tree independent of nodes of said clock tree. The clock tree typically comprises a single clock signal source (for example a clock signal generator and/or a clock signal input line or the like) and a plurality of sinks (typically some kind of circuitry that is clocked, in particular digital devices operating according to a clock signal like flip-flops or the like). Although a clock tree can comprise only two sinks, typically the number of sinks ranks in the order of 100 or even higher. Typically, the clock tree comprises several levels i.e. the clock tree comprises several stages of nodes. In other words, usually not only one node is (directly) distributing an input clock signal to a plurality of sinks, but typically a clock signal is first distributed to a first-order node which splits up the clock signal into two or more first-order signals, wherein one or a plurality of first-order signals is split up another time by "second-order nodes" into an increased number of second-order clock signal lines and so on. It has to be mentioned that the number of nodes between the root and the sinks does not have to be identical (although this is possible, of course). Furthermore, the distribution of an input clocking signal into a plurality of output clocking signals (independent on the level of the node) can vary as well; in particular, it can vary between two and a more or less unlimited number (although in practice the number is typically limited to 3, 4, 5, 6, 7, 8, 9 or 10 outgoing lines). A "node" is usually defined as essentially any kind of "electrical branch", i.e. a "branch" where an input signal is split up into two or more output signals. The method can preferably be carried out using a programmable device, in particular an electronic (digital) computer. The programming can be performed in form of software and/or in hardware (for example by some circuitry like integrated circuits or the like). According to the method, buffers are introduced into the clock tree. This is done on an (initially) "intermediary" basis, in a way that the buffer that is introduced does not necessarily have to remain within the final clock tree (whether at all and/or at the "initial" position). A "buffer" is typically a device that is amplifying an electric signal and/or a device that is somehow modifying an electric signal (like reshaping the signal, etc). After this "introducing step" (adding step) , one checks the effect of the buffer(s) on the clock signal at at least some of the sinks of said clock tree. This check can include, without limitation, the overall delay (for example the so-called Elmore delay), the skew rate, the slew rate, the pulse shape, the pulse level and so on. At least some of the effects do not necessarily have to be considered for all sinks, but can preferably be applied only to certain groups of sinks (simultaneously). For example, a skew rate (skew limit) has to be usually only applied to a certain group of sinks, namely typically the "members" of a local area. After this checking step has been performed, the respective "provisionally introduced" buffer is removed if adverse effects are obtained. The adverse effects can be related to a single value (for example to an overall delay, to a skew limit, to a slew limit and so on) or to a (presumably a weighted) mixture of parameters. It should be mentioned that "adverse effects" can be considered in a somewhat broad way. In particular, it is possible to even allow a slight increase in adverse effects, so that the method "has a chance" to leave a local minimum and to presumably obtain a better result in the end. In this way, "adverse effects" can be calculated by a certain type of function and a cut-off parameter can be defined (where the cut-off parameter can be chosen in a way so that some "not perfect" results can be (temporarily) accepted for the time being). In particular, these steps can be iteratively and/or recursively repeated to "approach a final result". According to the present suggestion, at least one buffer can be introduced into the clock tree independent of nodes of said clock tree. Previously known methods usually allowed only the introduction of a single buffer in connection with a node (i.e. typically a maximum number of one buffer per node was possible). Therefore, the presence of two buffers (or more) between two nodes was not possible. However, the introduction of possibly additional buffers proofs to (possibly) yield significantly improved results, since more flexibility can be provided. Surprisingly, if the method is performed according to some criteria and/or limitations, as set forth in the following, the computing power that is necessary for performing the presently suggested method will not explode, but can, on the contrary, be even decreased with respect to presently known algorithms. The notion "can be introduced" can be particularly interpreted in a way that during the working phase of the method (algorithm), buffers are "provisionally introduced" into the clock tree; however they do not necessarily have to remain at their current position (instead, they can be moved or removed). Another effect that has been observed by the inventors during first tests of the method is that it is now possible to optimise for a number of values. In particular, it is possible to optimise the clock tree with respect to slew rate, overall delay time (Elmore delay), power consumption and/or hotspots (where even more parameters can be additionally and/or alternatively considered).

It is suggested to perform the method in a way that at least one buffer can be introduced into at least one connecting line and/or at at least one node output connection. First experiments have shown that this will lead to a remarkably improved method with only an acceptable increase in computing time (if at all). The positioning of at least one buffer into at least one connecting line can be done in the middle of the line and/or shifted to one end of the line (asymmetric placement). A somewhat "extreme" example would be to position the buffer at one node's input and/or output connection (wherein a plurality of buffers can be provided at a plurality of nodes). The last case is preferably performed in a way that at a node, one can add a buffer at the position of the node and an additional buffer for every outgoing line of the node. Although it is in principle possible to use buffers with an identical or similar electric behaviour, it is preferred if different buffers can be used. In particular, it is possible to choose a buffer out of a certain "initial set" of buffers and/or to use a certain type of buffer for a certain type of position.

Preferably, the method is performed in a way that the presence of adverse effects is at least in part determined using a cost function. This way, it is particularly easy to achieve an improved "overall output". In particular, it is possible to accept a somewhat inferior value for a certain type of parameter and/or at a certain position, if this will result in sufficiently large improvements at at least another position and/or of another parameter. The same can apply, at least in analogy, if this is the only (reasonable) way to fulfil any "mandatory" requirements like certain technical specifications. This way, the "overall net effect" can be considered.

Furthermore, it is suggested to perform the method in a way that the presence of adverse effects is at least in part determined by assigning every buffer an individual weight, in particular in a way that said weight is used for said cost function. The weight of a buffer does not necessarily have to be a single value and/or has to be calculated from a single parameter. Instead, it is preferred to use several "input parameters", for example at least one parameter taken from the group comprising: area of the buffer, power consumption of the buffer, heat generation by the buffer, time delay introduced by the buffer, signal form alteration by the buffer and/or susceptibility of the buffer with respect to working condition variations. However, the list is not exhaustive.

It is further suggested to perform the method in a way that the presence of adverse effects is at least in part determined using a severance grade, expressing the susceptibility to process variations, in particular in a way that said severance grade is used for said cost function. The susceptibility to process variations does not necessarily have two relate only to the buffers. Instead, it is even preferred if the susceptibility to process variations is also considered for other components, like the electrical lines, the behaviour of components connected to the clock tree, the number and distribution of hotspots and the like.

Furthermore it is suggested to perform the method in a way that the position of at least one of said buffers can be moved. In particular, the respective buffer can be moved along an electric line. This way, the ratio between the windward fraction and the downwind fraction of the line (with respect to the buffer) can be changed. Additionally and/or alternatively at least one of said buffers can be altered. As an example, buffers with different electrical properties can be considered. This way, it is possible (as an example), to use a buffer with an increased power consumption and/or area for construction of the clock tree if an improvement can be obtained in a way that an improved net effect can be reached.

In particular it is suggested to perform the method in a way that skew limits and/or slew limits are verified when constructing the clock tree. This way, a particularly powerful and/or small and/or reliable clock tree (and hence an integrated circuit) can be realised. As already indicated, the skew limits and/or the slew limits can apply for only groups of sinks of the clock tree and/or can apply groupwise to the several groups of sinks of the clock tree.

Preferably, the method is performed in a way that nodes can be erased, preferably in dependence of a preferably variable skew limit and/or slew limit. This way, the clock tree can be simplified. As a consequence (although not necessarily mandatory) buffers can be deleted as well. A node can be erased (and a somewhat decreased quality of a skew limit and/or a slew limit) can be considered, if the overall net effect is positive. This, however, usually applies only to a "soft limit", and usually not to a "hard limit" (which is for example defined in the specifications; wherein "hard limit" means that the resulting integrated circuit will not operate anymore and/or will only operate at an unacceptably low reliability level if said limit is exceeded). This design can even lead to certain advantages, in particular in a way that a spread of the clock signal is reached, so that hotspots can be reduced.

Furthermore, it is suggested to perform the method in a way that several stages are performed when carrying out the method. In particular, an initial construction stage, a first optimisation stage and/or a second optimisation stage can be used. It should be noted that the different stages do not necessarily have to comprise the same complexity and/or the same steps. As an example, in an initial construction stage, buffers are only placed at certain positions. Only after an "initial clocking tree" has been constructed (for example during an initial construction stage), the positions of the buffers and/or the buffers are altered (for example during a first optimisation stage and/or during a second optimisation stage).

Furthermore an electronic device is suggested, in particular a digital unit and/or an integrated circuit, wherein the electronic device comprises at least one clock tree that is constructed using a method of the afore described type.

This way, the electronic device can show the same features and improvements, at least in analogy. Of course, the electronic device can be modified according to the previous description as well, at least in analogy.

Furthermore, a computer program product is suggested, when the computer program product is designed and arranged in a way that a method according to the previous description will be employed, when the computer program product is loaded into a computer device.

Lastly, a construction device is suggested, which is designed and arranged in a way that the construction device performs a method according to the previous description, in particular if a computer program product is used in connection with the construction device. As an example, the construction device can be a (standard) digital computer.

The present invention and its advantages will become more apparent, when looking at the following description of possible embodiments of the invention, which will be described with reference to the accompanying figures, which are showing:
- Fig. 1:: a possible clock tree that was constructed according to a first embodiment of the presently suggested construction method in a schematic drawing;
- Fig. 2:: a schematic flowchart of a first possible embodiment of a construction method for a clock tree;
- Fig. 3:: a subroutine of the first embodiment of a construction method for a clock tree in a more detailed flowchart;
- Fig. 4:: a comparison of the distribution of nodes of a model chip with a clock tree that was constructed with a method according to the state-of-the-art and with the presently suggested method.

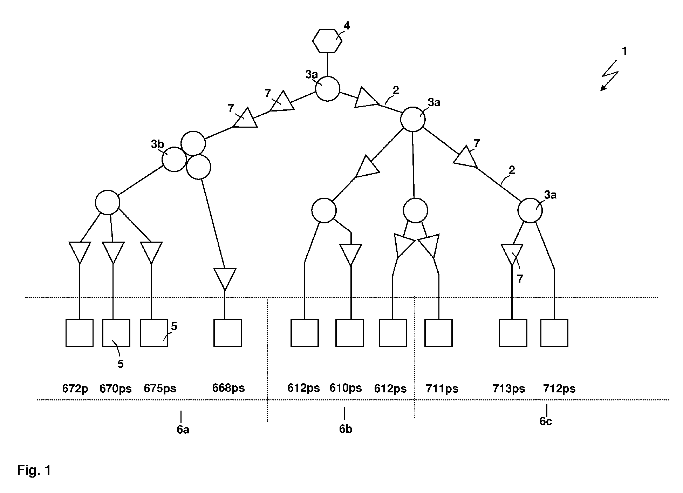

In Fig. 1 a first possible example of a clock tree 1 that was constructed using the presently suggested method is shown in a schematic and simplified representation. It has to be understood that the actual lengths of the respective electrical wires 2 are schematically drawn (i.e. their lengths in Fig. 1 are not a representation of their actual lengths on a computer chip).

Furthermore, the clock tree 1 is further simplified, since the levels of nodes are usually more numerous. Furthermore, quite often the individual nodes 3 have more outgoing electrical wires 2, as well. In combination, the clock tree 1 distributes the clock signal that is generated by a central clock generator 4 to a (in reality typically larger) number of individual sinks 5, which are presently indicated as squares in Fig. 1. Of course, the sinks 5 can represent a large amount of different types of electronic circuits that have to be clocked. As an example, a node 5 can stand for a clocked flip-flop or any other device that is usually found on an integrated circuit (like an inverter, an equalizer or the like).

Nowadays, a single integrated circuit (at least integrated circuits with a more complex design and/or with a higher complexity) shows an area that is comparatively large, for example in the order of several mm². When additionally considering the typical clock rates that are used nowadays (for example in the GHz range), one can realise that it is not possible any more to clock all different circuits (sinks 5) more or less simultaneously (i.e. Sufficiently close to each other so that the allowed time variations - in particular a slew rate and skew rate - are not exceeded). Therefore, integrated circuits are usually "logically" divided into a plurality of local areas 6. These local areas 6 are indicated in Fig. 1 as dashed rectangulars. Every local area 6 contains a plurality of sinks 5 (where the exact number of sinks 5 does not necessarily has to be the same).

The clock tree 1 is designed in a way that the clock signal that is distributed by the clock tree 1 arrives at the various sinks 5 within a single local area 6 in a way that the corresponding circuits can operate "together". In other words, the signals that arrive at the individual local areas 6 have to obey certain specified standards. As a predominant example, the skew rate and the slew rate of the clock signals at the sinks 5 of a single local area 6 have to obey the standard (where the skew rate of sinks 5 that belong to different local areas 6 may breach the standard).

For illustrative purposes, examples of some delay times between the central clock generator 4 and the individual sinks 5 are indicated. In the presently shown example, a maximum skew rate of 7.5 ps is assumed. As can be seen in Fig. 1, the "leftmost" local area 6a contains nodes that are obeying a maximum skew rate of 7.5 ps (to be more exact, the maximum spread is 7 ps between a delay of 668 ps and 675 ps). In the "middle" local area 6b, the maximum skew rate is 4 ps; while in the "rightmost" local area 6c, the skew rate is 2 ps. Hence, in every individual local area 6a, 6b, 6c, the maximum skew limit is obeyed. However, between two different local areas 6a, 6b, 6c, the maximum skew rate of presently 7.5 ps is not obeyed (and hence the individual local areas 6 have to communicate and/or interoperate in a somewhat different way as it is possible as compared to the circuits within a single local area 6).

The adaption of the clock signals at the individual sinks 5 is done by appropriately adjusting a variety of means. A first influence occurs from the lengths of the individual electrical wires 2. In particular, one has to note that the delay time that occurs when propagating along an electrical wire 2 increases (approximately) quadratically with the length of the wire 2. Therefore, by appropriately placing nodes 3 and buffers 7 (which are typically some kind of amplifiers), the propagation times can be influenced quite significantly. Of course, one has to keep in mind that every node 3 and every buffer 7 brings along an individual delay time on its own. In particular, the delay time generated by a buffer 7 is dependent on the actual design of the individual buffer 7, as well. Therefore, the number of degrees of freedom is very high.

Of course, typically even more influences are present, which is known in the state-of-the-art. As an example, the distance between two electrical wires 2 (due to their capacitance), the number of changes between two different conducting layers ("metal layers") or the like have an influence on the propagation time (and other parameters like the signal shape) as well.

Although not shown and/or exhaustively mentioned, other parameters are influenced by the design of the clock tree 1 as well, where a predominant example is the slew rate.

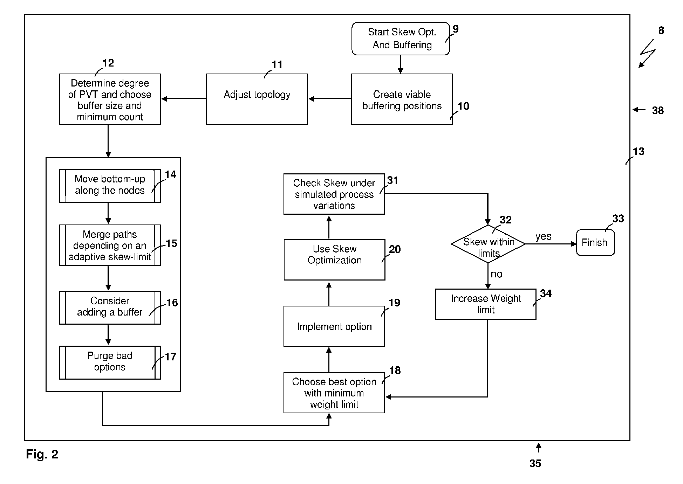

In Fig. 2 a flowchart for an algorithm 8 for constructing a clock tree (for example the clock tree 1 in Fig. 1) of an integrated circuit is schematically shown as a flowchart.

The algorithm 8 starts at step 9.

In the beginning (step 10), a clock tree 1 is constructed in a way that the geometrical considerations of the chip design are taken into account. A major part of the adaption of the clock signals at the sinks 5 is done by adding buffers 7. In particular, one has to realise that the placement of the buffers 7 is not limited in any way by the presence or non-presence of a node 3. Therefore, an interconnecting line 2 between two nodes 3 (or the clock generator 4 and the first node 3 and/or a "lowest level" node 3 and a sink 5) can show essentially any number of buffers 7, in particular 0, 1, 2, 3, 4 or 5. However, the algorithm 8 tries to use comparatively few buffers 7, because every buffer 7 needs some space on the chip and uses some power, when operating (both effects are undesired). As an example, adding a buffer 7 can be performed by splitting up an electrical wire 2 into two or more sections. This is the so-called "create viable buffering positions" step 10.

After this step 10, a step 11 for adjusting the topology is initiated. In this step, every node 3 with two (or more) child nodes 3 is split up (see double node 3b in Fig. 1) so that the new child nodes are at the same position as the upper node and may serve as (additional) buffering places. This allows direct buffering at the beginning of the respective connecting electrical wires 2.

After this, in another step 12, the degree of PVT (i.e. the susceptibility to process variations; PVT = Process Voltage Temperature), the buffer sizes (of the buffers 7 used) and the number of buffers 7 that are used are evaluated. This information is used as input data for generating a cost parameter (a "weight") for the individual clock tree topology in question. The cost function can include, without limitation, the size of the circuit, the location of the sinks, the amount of sink capacitance, technology parameters, power consumption, temperature variations, and so on. Now a certain cut-off limit can be applied so that only sufficiently promising basic clock tree topologies ("viable topologies") are considered in the following steps. By purging non-viable topologies, a significant amount of (unnecessary) calculations can be saved. This saving in computational power can be used for speeding up the whole process and/or for improving the overall design.

Now, after these first initial steps 38, a so-called bottom-up process 13 is started. Here, viable buffering options are determined and parameters are computed. In the bottom-up phase 13, one moves 14 up from the bottom (i.e. from the sinks 5) to the top (i.e. towards the clock generator 4) along the nodes 3.

When moving upwards, paths 2 are merged 15 depending on an adaptive skew limit. When handling a node with two child nodes ("double node" 3b), inferior solutions or inferior option sets should be merged (i.e. only more promising designs are further considered). This is essentially done by applying a skew limit. However, the skew limit is not only necessarily applied as a cut-off parameter (wherein the specifications must be met, of course), but the skew limit for this step 15 can be adaptive. As an example, it can depend on multiple factors such as the minimum or maximum skew of two topology subsets. In other words, a slightly inferior solution might be still favourable because it brings forth significant improvements with respect to other parameters.

After this merging step 15, in another step 16, adding of a buffer is considered. For each of the (remaining) possible options at node 3, it is calculated what would happen if an (additional) buffer 7 would be inserted. If an improvement is identified (wherein the improvement can also consist as an improvement on a "large-scale view") this option is maintained and added to the possible set of options (that is considered for the remaining algorithm 8). Examples for such an "improvement" might be with regard to delay, capacitance, area and clock skew.

Now, in another step 17, bad options of the remaining set of options are purged. This can be done by comparing the cost parameter (weight) of the various remaining options. As an example, if the slew rate is too high, or if the cost (with respect to area, buffer amount or buffer sizes) is too high or if a better solution with regard to skew, delay, capacitance and/or area has been found, inferior solutions might be purged. This way, those options are not further considered so that calculation time can be saved.

Now, and optimisation loop 35 is started. Firstly out of the remaining, viable options, in a step 18, the presently best option is chosen. Typically, initially the option with the lowest weight is chosen for the next couple of steps. One has to note that this option is already a quite good solution and that the next steps will only lead to a further improvement of the overall clock tree. The improvements that can be achieved by this typically range in the 10 % to 20 % range. The "temporarily optimal" solution typically requires an essentially minimum number of components and an essentially minimum source-to-sink delay time.

Now, the "implement option" step 19 is initiated. Here, the option is recursively implemented into the clock tree 1. This means that the buffers 7 are placed at the positions that were previously determined (it has to be noted that a change might occur if in a later cycle the weight limit has been increased).

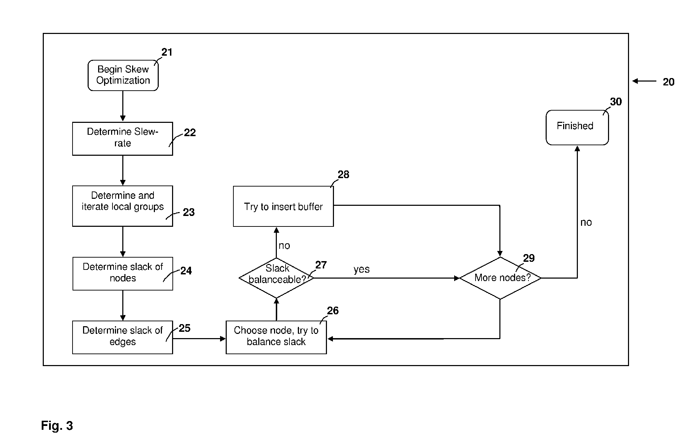

Now the skew optimisation step 20 is started. This skew optimisation step 20 is more elaborately shown in Fig. 3.

After starting 21 the subroutine, first the slew rate is determined 22 at all nodes 3 within the clock tree 1.

The slew rate can be calculated (estimated) with methods that are known in the state-of-the-art. In particular it has to be noted that at least up to a certain extent computation time can be saved by using previously derived results. In particular, usually an estimation of the slew rate has already been calculated during the step 10 in which viable buffering positions have been were calculated, or during the step 16 in which adding of a buffer is was considered.

The remaining steps 23 to 30 of subroutine 20 are performed for every local group of the chip for which the clock tree 1 is calculated. Therefore, the following steps 23 to 30 (for step 23 only the iteration step) are usually run through for several times. A "local group" is usually defined as the respective branch of a clock tree 1 that is feeding the sinks 5 within a local area 6. Hence, the local group typically comprises a plurality of nodes 3, wherein the respective nodes 3 typically belong to two or even more different levels of the clock tree 1.

In the beginning of this series of steps, in a first step 23 the local groups that are present are determined. The local groups are determined by first determining groups of local sinks 5 i.e. sinks 5 that belong to the same local areas. From this, the local groups (i.e. the nodes 3 belonging to the respective local groups) are determined. This is advantageous because the skew rate has to obey the strict limits only within a local area. Therefore, only nodes 3 and/or sinks 5 within a certain branch said local area have to be adapted to each other with regard to skew rate. This way, usually fewer buffers 7 are necessary, usually resulting in a smaller and less power consuming chip.

Now, the next couple of steps are first initiated with a first local group (and are repeated later on with the next local group in line and so on, i.e. the local groups are iterated).

Now, for each node 3 in the respective local group, in a first step 24 the clock-slack is calculated. The clock-slack is simply the difference between the maximum delay of any of the nodes 3 within the current local group (i.e. in other words the "latest node 3") and the delay of the currently considered node 3. The thus determined difference is equivalent to the delay that has to be added to the respective node 3 so that the clock skew within the local group is balanced. If no further actions are performed, the clock skew will be optimised to be essentially zero. As already explained, this is nowadays considered to be disadvantageous. Therefore, according to the present example the difference will be subtracted by a certain number and a (modified) clock-slack that is lower than zero is considered to be zero. This way, the clock skew will be different from zero, but will remain within limits as set forth in the specifications (if the subtractive number is appropriately chosen). After this step 24 (determining the slack of the nodes), and in the next step 25 the slack of the edges is determined. The edges are the connections between nodes 3 of the different levels. Therefore, the clock-slack of an edge can simply be determined by subtracting the clock-slack of the upper node from the clock-slack of the lower node of the respective edge ("interconnecting wire").

Now, in step 26 a node 3 within the currently processed local group that has not yet been considered is chosen for being processed in the next couple of steps 27-29. In particular, the algorithm tries to balance this the clock skew of the nodes within the local group by adjusting the delay (in the present step mainly by adding a delay). The overall amount of the desired delay is equivalent to the clock-slack of all edges that have been determined in the preceding steps. An If necessary, an appropriate time delay can be added by essentially any means according to the state-of-the-art, for example by wire snaking (i.e. by adding some loops or detours of the respective electrical line 2) and/or by changing the position of the nodes 3 (which cannot only increase a delay, but can als lead to a shortening of a delay under certain conditions).

In interrogation step 27 it is checked whether the skew balancing according to the previous step 26 was successful. If so, the algorithm jumps to step 29, where it is checked whether all nodes 3 have been processed. If there are any nodes 3 left, the algorithm jumps back, processing the next node 3 (step 26). (However, if the nodes 3 within a local group are completed, the next local group will be chosen; (see step 23). Of course, if all nodes 3 have been processed, no further action is required and the subroutine 20 is finished 30, so that the algorithm 8 continuous continues according to Fig. 2 with the next step 31.

If, however, it is determined in step 27 that the balancing of the skew was not successful, the algorithm aims to repair the clock skew in a way that it comes is brought back within the specifications. Since wire snaking and/or changing the position of the nodes 3 was not successful (see step 26), the only option left is to insert a buffer 7, which is done in step 28.

This way all nodes 3 (all respective nodes 3 within every local group) are processed and the subroutine 20 finishes at step 30.

Now the skew optimisation step 20 is finished (step 30) and the algorithm 8 continues with the next step in Fig. 2.

The next step is a step 31, in which the skew rate is checked under simulated process variations. Here, variations that might occur during operation of the assembled chip (for example due to waste heat, environmental impact, voltage variations and so on) are simulated. If despite of these operating variations the skew is still within limits (interrogation step 32), the overall algorithm 8 is finished 33 and the solution is outputted.

If, however, this check 32 fails, another solution has to be sought. This is implemented by increasing the weight limit 34 and the optimisation loop 35 is re-entered at step 18.

Even if the optimisation loop 34 is passed for several times (and thus the weight is increased several times), one has to note that the "adverse effects" that are brought forth by increasing the weight are still quite low under realistic conditions.

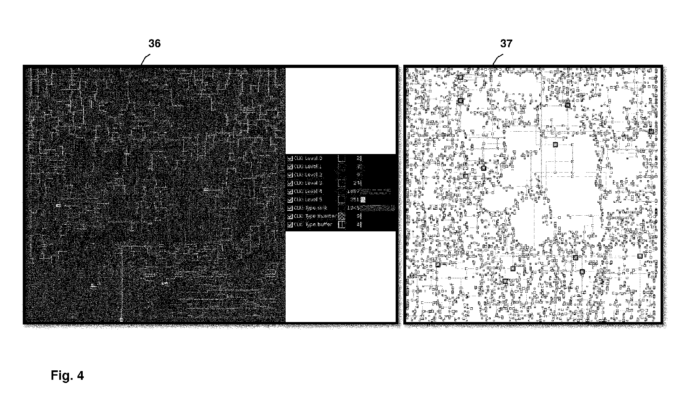

A typical example for the advantages of the presently proposed method can be seen in Fig. 4. Here, on the left side an optimised chip design 36 by using a method according to the state-of-the-art is shown. On the right side, however, an improved chip design 37 by using the presently proposed method is shown.

Just to give some numbers, the state-of-the-art-solution 36 results in a clock skew of 68 ps, using 11 buffers. With the improved design 37 that has been achieved by the presently proposed method, the clock skew is as low as 0.19 ps with the use of 16 buffers. Therefore, by using somewhat more buffers (approximately 50 % more buffers, where the usage of buffers is per se disadvantageous due to their power consumption and the area needed), a significant improvement of the chip design can be realised. Therefore, the disadvantages of the additional buffers are more than counterbalanced by the improved chip design.

### Reference list

- 1.: clock tree
- 2.: electrical wires
- 3.: node
- 4.: clock generator
- 5.: sink
- 6.: local area
- 7.: buffer
- 8.: construction algorithm
- 9.: start
- 10.: create viable buffering positions step
- 11.: adjust topology step
- 12.: determine degree of PVT and choose buffer size and minimum count step
- 13.: bottom-up process
- 14.: move bottom-up along the nodes step
- 15.: merge path depending on an adaptive skew limit
- 16.: consider adding a buffer step
- 17.: purge bad options step
- 18.: choose best option with minimum weight limit step
- 19.: implement options step
- 20.: use skew optimisation step

- 21.: start
- 22.: determine slew rate step
- 23.: determine and iterate local groups step
- 24.: determine slack of nodes step
- 25.: determine slack of edges step
- 26.: choose node step
- 27.: slack balanceable?-interrogation
- 28.: try to insert buffer step
- 29.: more nodes?-interrogation
- 30.: stop
- 31.: check skew under stimulated process variations step
- 32.: skew within limits?-interrogation
- 33.: stop
- 34.: increase weight limit step
- 35.: optimisation loop
- 36.: current chip design (state-of-the-art)
- 37.: improved chip design
- 38.: initial steps

## Claims

1. Method (8) for constructing a clock tree (1) in an electronic device (36, 37), in which a central clock signal is distributed to a plurality of sinks (5), said method (8) comprising the steps of
(a) introducing (10, 16) buffers (7) into the clock tree (1),
(b) checking (12, 15, 22, 23, 24, 25, 31) their effect on the clock signal at at least some of the sinks (5) of said clock tree (1), and
(c) removing (17, 34) the respective buffer (7) if adverse effects are obtained, **characterised in that** at least one buffer (7) can be introduced into the clock tree (1) independent of nodes (3) of said clock tree (1).

2. Method (8) according to claim 1, **characterised in that** said at least one buffer (7) can be introduced into at least one connecting line (2) and/or at at least one node (3) output connection.

3. Method (8) according to claim 1 or 2, **characterised in that** the presence of adverse effects is at least in part determined using a cost function.

4. Method (8) according to any of the preceding claims, in particular according to claim 3, **characterised in that** the presence of adverse effects is at least in part determined by assigning every buffer (7) an individual weight, in particular **characterised in that** said weight is used for said cost function.

5. Method (8) according to any of the preceding claims, in particular according to claim 3 or 4, **characterised in that** the presence of adverse effects is at least in part determined using a severance grade, expressing the susceptibility to process variations, in particular **characterised in that** said severance grade is used for said cost function.

6. Method (8) according to any of the preceding claims, **characterised in that** the position of at least one of said buffers (7) can be moved and/or **characterised in that** at least one of said buffers (7) can be altered.

7. Method (8) according to any of the preceding claims, **characterised in that** skew limits and/or slew limits are verified when constructing the clock tree (1).

8. Method (8) according to any of the preceding claims, **characterised in that** nodes (3) can be erased, preferably in dependence of a preferably variable skew limit and/or slew limit.

9. Method (8) according to any of the preceding claims, **characterised in that** the method (8) comprises several stages (13, 35, 38), in particular an initial construction stage (38), a first optimisation stage (13) and/or a second optimisation stage (35).

10. Electronic device (37), in particular digital unit and/or integrated circuit, **characterised by** at least one clock tree that is constructed using a method according to any of claims 1 to 9.

11. Computer program product that is designed and arranged in a way that it performs a method (8) according to any of claims 1 to 9, when loaded into a programmable computer.

12. Construction device that is designed and arranged in a way that it performs a method (8) according to any of claims 1 in 9, in particular when used with a computer program product according to claim 11.
